# EUROPEAN PATENT SPECIFICATION

(11) **EP 3 073 540 B1**
(45) Date of publication and mention of the grant of the patent: **08.05.2019**
(21) Application number: 16161069.6
(22) Date of filing: 18.03.2016
(51) Int. Cl.: H01L 41/08, B41J 2/14, H01L 41/187, H01L 41/318, H01L 41/319

(54) **PIEZOELECTRIC ELEMENT, PIEZOELECTRIC ELEMENT APPLICATION DEVICE, AND METHOD OF MANUFACTURING PIEZOELECTRIC ELEMENT**
PIEZOELEKTRISCHES ELEMENT, ANWENDUNGSVORRICHTUNG FÜR PIEZOELEKTRISCHES ELEMENT UND VERFAHREN ZUR HERSTELLUNG EINES PIEZOELEKTRISCHEN ELEMENTS
ÉLÉMENT PIÉZOÉLECTRIQUE, DISPOSITIF D'APPLICATION D'ÉLÉMENT PIÉZOÉLECTRIQUE ET PROCÉDÉ DE FABRICATION D'UN ÉLÉMENT PIÉZOÉLECTRIQUE

(30) Priority: 27.03.2015 JP 2015067490
(43) Date of publication of application: 28.09.2016
(73) Proprietor: Seiko Epson Corporation, Shinjuku-ku Tokyo (JP)
(72) Inventor: SUMI, Koji, Suwa-shi, Nagano 392-8502 (JP); KOBAYASHI, Tomokazu, Suwa-shi, Nagano 392-8502 (JP); KITADA, Kazuya, Suwa-shi, Nagano 392-8502 (JP)
(74) Representative: Miller Sturt Kenyon

(56) References cited:
- JP-A- 2007 019 302
- US-A1- 2005 185 026
- US-A1- 2008 303 377
- US-A1- 2009 189 482
- US-A1- 2012 289 807
- US-A1- 2013 127 293
- NAKASHIMA Y; SAKAMOTO W; MAIWA H; SHIMURA T; YOGO T: "Lead-Free Piezoelectric (K,Na)NbO3 Thin Films Derived from Metal Alkoxide Precursors", JAPANESE JOURNAL OF APPLIED PHYSICS, vol. 46, no. 14, 30 March 2007 (2007-03-30), pages L311-L313, XP9508991, ISSN: 0021-4922, DOI: 10.1143/JJAP.46.L311

## Description

### BACKGROUND

### 1. Technical Field

The present invention relates to a piezoelectric element, a piezoelectric element application device, and a method of manufacturing a piezoelectric element.

### 2. Related Art

A piezoelectric element generally includes a piezoelectric layer having electromechanical conversion characteristics and two electrodes that pinch the piezoelectric layer. Development of devices (piezoelectric element application devices) in which the piezoelectric element is used as the driving source is actively performed in recent years. Examples of the piezoelectric element application device include liquid ejecting heads represented by ink jet recording apparatuses, MEMS elements represented by piezoelectric MEMS elements, ultrasound measurement devices represented by ultrasound sensors, and piezoelectric actuator devices.

Potassium sodium niobate (KNN; (K, Na) NbO₃) is proposed as one material (piezoelectric material) of the piezoelectric layer of the piezoelectric element (for example, refer to JP-A-2008-305916 and JP-A-2009-200468). JP-A-2008-305916 discloses a piezoelectric body that is a piezoelectric film formed by a crystal with (NaₓK_{y}Li_{z})NbO₃ as a main phase, and the piezoelectric film is a polycrystalline thin film that is preferentially oriented on either or both crystal axes of the (001) axis and the (110) axis in the normal line direction of the surface of the substrate, the crystals oriented on each of the crystal axes are formed so the crystal axes also have the same orientation in the in-plane direction of the substrate. JP-A-2009-200468 discloses a piezoelectric thin film element for which the orientation rate to the (001) planar orientation of the piezoelectric thin film is 80% or more, and the 2θ angle of the diffraction peak due to the (001) plane of the piezoelectric thin film in the X-ray diffraction pattern (2θ/θ) is in the range of 22.1°≤2θ≤22.5°.

However, the piezoelectric thin film in JP-A-2008-305916 is a single crystal and the crystal orientation is even in a specified direction in the in-plane direction. Because cleavage fractures easily occur in the crystal, the crystal is not suitable to use as an actuator that uses mechanical deformation.

In JP-A-2009-200468, the diffraction peak of the (001) plane of KNN is defined as a state in which residual stress is 0 or substantially not present, and the 2θ angle is favorable in a range of 22.1°≤2θ≤22.5°. However, since the KNN crystal system near the morphotropic phase boundary (MPB) is a monoclinic system, and the polarization axis of the monoclinic system is distributed on the c axis or in a direction inclined from the c axis, the displacement corresponding to a behavior where the polarization rotates when an electrical field is applied appears. This becomes a displacement that is a non-linear action and is not reusable due to pinning of the polarization. Thus, in the case where used as an actuator, a problem arises in that deterioration of the durability of the displacement is significant. In a case where used as a sensor, by the driving voltage dependency of the displacement including non-linear region, a problem arises where driving control becomes difficult.

JP 2007 019302 discloses a piezoelectric thin film element having a lower electrode provided on a substrate, a piezoelectric thin film and an upper electrode. The piezoelectric thin film material is formed of perovskite compound of alkali-niob oxide system expressed by a general expression, (NaxKyLiz)NbO3 (0<x<1, 0<y<1, 0≤z<1, x+y+z=1). A thin film of a material which has a perovskite type crystal structure and is easily oriented in higher degree of orientation to any of the plane orientations of (001), (100), (010), and (111) is provided as a buffer layer between the piezoelectric thin film and the lower electrode.

US 2013/0127293 discloses a piezoelectric thin-film element production method wherein a lower electrode layer is provided on a substrate, a piezoelectric thin-film buffer layer is formed on the lower electrode layer, a piezoelectric thin-film layer is formed on the piezoelectric thin-film buffer layer (at a higher film-formation temperature than that for the piezoelectric thin-film buffer layer), and an upper electrode layer is formed on the piezoelectric thin-film layer. Y. Nakshima et al. Jpn. J. Appl. Phys. 46 (2007) L311-L313 shows a KNN film with preferential (011) orientation on a Pt/TiOₓ/SiO₂/Si substrate.

### SUMMARY

An advantage of some aspects of the invention is to provide a piezoelectric element, a piezoelectric element application device, and a method of manufacturing a piezoelectric element with superior linearity of displacement for the applied voltage, and superior displacement characteristics.

According to an aspect of the invention, there is provided a piezoelectric element, including a first electrode formed on a substrate, a piezoelectric layer which is formed on the first electrode and includes a complex oxide with an ABO₃-type perovskite structure represented by the following formula (1); and a second electrode formed on the piezoelectric layer, in which a seed layer including a complex oxide with an ABO₃-type perovskite structure in which K and Nb are included between the first electrode and the piezoelectric layer, and the piezoelectric layer is formed from a polycrystal that is preferentially orientated on the (110) plane.

(K_{X}, Na_{1-X})NbO₃ (1)

In the aspect, a piezoelectric element is obtained in which the piezoelectric layer is preferentially oriented on the (110) plane, the linearity of displacement for the applied voltage is superior, and the displacement characteristics are improved due to the predetermined seed layer.

Here, it is preferable that an X-ray diffraction peak position (2θ) derived from the (110) plane of the piezoelectric layer is 31.6° or more to 32.5° or less. Accordingly, a piezoelectric element is obtained in which the linearity of displacement for the applied voltage is superior and the displacement characteristics are improved.

It is preferable that, in formula (1), x is greater than 0 to 0.94 or less. Accordingly, a piezoelectric element is obtained in which the linearity of displacement for the applied voltage is superior and the displacement characteristics are improved.

It is preferable that the piezoelectric layer has a thickness of 50 nm or more to 2000 nm or less. Accordingly, since the tensile stress is imparted on the piezoelectric layer, the diffraction peak 2θ of the (110) plane is more reliably entered into a predetermined range.

It is preferable that the piezoelectric layer is prepared by a wet method. Accordingly, it is possible to comparatively easily manufacture a piezoelectric layer having internal stress and the diffraction peak 2θ of the (110) plane is more reliably entered into a predetermined range.

According to another aspect of the invention, there is provided a piezoelectric element application device that includes any one of the disclosed piezoelectric elements.

According to the aspect, a piezoelectric element application device can be provided that includes a piezoelectric element in which the piezoelectric layer is preferentially oriented on the (110) plane due to the predetermined seed layer, the linearity of displacement for the applied voltage is superior, and the displacement characteristics are improved.

According to still another aspect of the invention, there is provided a method of manufacturing a piezoelectric element that includes a first electrode formed on a substrate, a piezoelectric layer which is formed on the first electrode and includes a complex oxide with an ABO₃-type perovskite structure represented by the following formula (1), and a second electrode formed on the piezoelectric layer, the method including forming a seed layer including a complex oxide with an ABO₃-type perovskite structure in which K and Nb are included on the first electrode; and forming the piezoelectric layer on the seed layer to be preferentially oriented on the (110) plane.

(K_{X}, Na_{1-X})NbO₃ (1)

According to the aspect, a piezoelectric element can manufactured in which the piezoelectric layer is preferentially oriented on the (110) plane due to the predetermined seed layer, the linearity of displacement for the applied voltage is superior, and the displacement characteristics are improved.

### BRIEF DESCRIPTION OF THE DRAWINGS

Embodiments of the invention will now be described by way of example only with reference to the accompanying drawings, wherein like numbers reference like elements.
Fig. 1 is a diagram illustrating a schematic configuration of a recording apparatus.
Fig. 2 is an exploded perspective view illustrating a schematic configuration of a recording head.
Figs. 3A and 3B are a plan view and a cross-sectional view of the schematic configuration of the recording head.
Figs. 4A to 4D are diagrams illustrating a manufacturing example of the recording head.
Figs. 5A to 5C are diagrams illustrating a manufacturing example of the recording head.
Fig. 6 is a diagram illustrating the X-ray diffraction pattern in Examples 1 to 4.
Fig. 7 is a diagram illustrating a relationship between the position (2θ) of the X-ray diffraction pattern and x in the examples.
Fig. 8 is a diagram illustrating a comparison of the displacement amounts in Example 2, and the comparative example.

### DESCRIPTION OF EXEMPLARY EMBODIMENTS

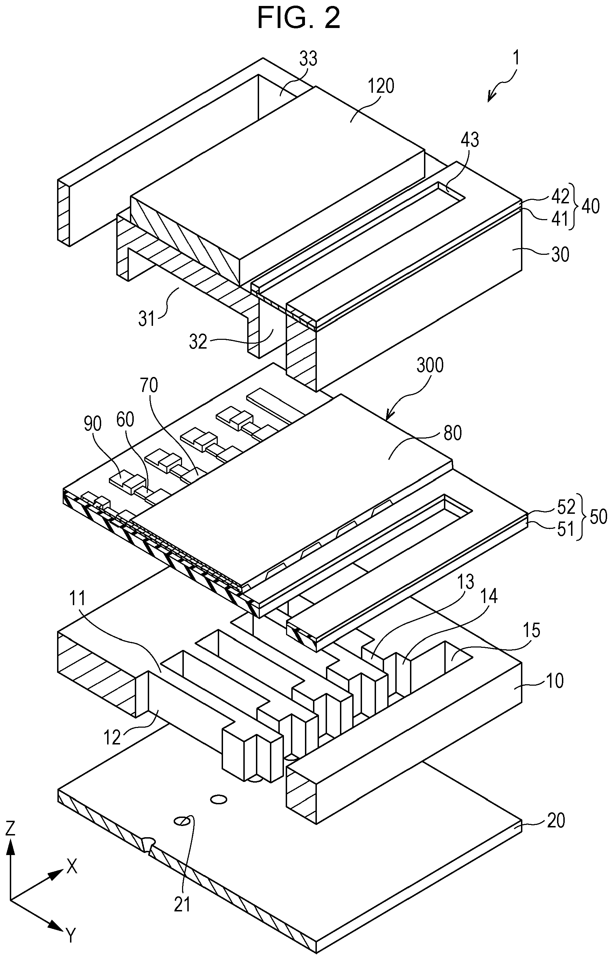

Below, embodiments of the invention will be described with reference to the figures. The descriptions below show one form of the invention, and arbitrary modifications are possible within the scope of the invention. In each drawing, members given the same reference numerals indicate the same member and description will not be repeated, as appropriate. In Figs. 2 to 5C, X, Y, and Z represent three mutually orthogonal spatial axes. In the specification, the directions along the axes are described as the X direction, the Y direction, and the Z direction, respectively. The Z direction represents the thickness direction or the film stacking direction of the plate, layers, and films. The X and Y directions represent the in-plane directions of the plates, layers, and films.

### Embodiment 1

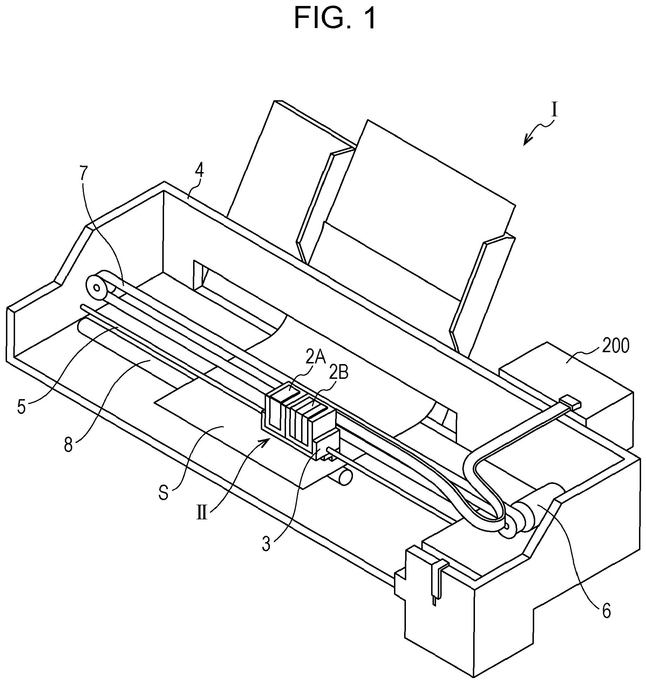

Fig. 1 illustrates a schematic configuration of an ink jet recording apparatus (recording apparatus) that is an example of a liquid ejecting apparatus.

In the ink jet recording apparatus I, the ink jet recording head unit (head unit II) is provided with cartridges 2A and 2B to be detachable. The cartridges 2A and 2B configure an ink supply unit. The head unit II includes a plurality of ink jet recording heads (recording heads) and is mounted to a carriage 3. The carriage 3 is provided on a carriage shaft 5 attached to the apparatus main body 4 to freely move in the axial direction. The head unit II and the carriage 3 are configured to be able to discharge a black ink composition and a color ink composition.

The driving force of a driving motor 6 is transmitted to the carriage 3 via a plurality of gears, not shown, and a timing belt 7. In so doing, the carriage 3 is moved along the carriage shaft 5. Meanwhile, a transport roller 8 is provided as a transport unit in the apparatus main body 4. A recording sheet S that is a recording medium such as a paper is transported by the transport roller 8. The transport unit is not limited to a transport roller, and may be a belt, drum, or the like.

A piezoelectric element is used as a piezoelectric actuator device in the ink jet recording head. By using piezoelectric element described in detail later, it is possible to avoid lowering of various characteristics (such as durability and ink ejection characteristics) of the ink jet recording apparatus I.

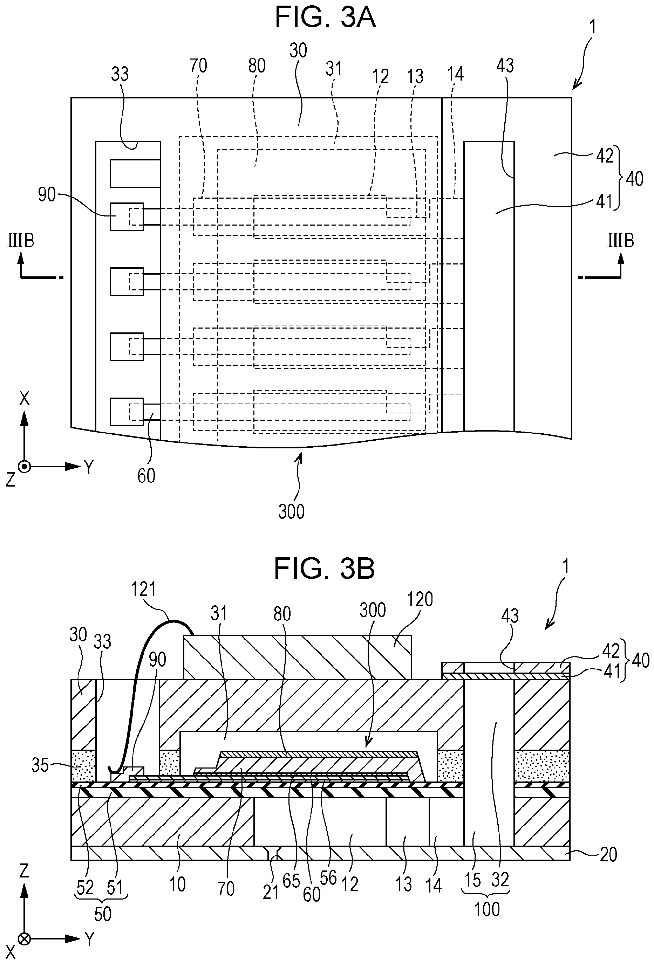

Next, the ink jet recording head will be described. Fig. 2 is an exploded perspective view illustrating a schematic configuration of an ink jet recording head. Fig. 3A is a plan view illustrating a schematic configuration of an ink jet recording head (plan view in which the flow channel-forming substrate is seen from the piezoelectric element side), and Fig. 3B is a cross-sectional view taken along line IIIB-IIIB in Fig. 3A.

A plurality of dividing walls 11 is formed on the flow channel-forming substrate 10. A plurality of pressure generating chambers 12 is partitioned by the dividing walls 11. That is, the pressure generating chambers 12 are arranged in parallel along the X direction (direction in which the nozzle openings 21 that discharge the same color of ink are arranged in parallel) on the flow channel-forming substrate 10. It is possible to use a silicon single crystal substrate as the flow channel-forming substrate 10.

An ink supply path 13 and a communication path 14 are formed on one side in the Y direction of the pressure generating chambers 12 of the flow channel-forming substrate 10. The ink supply path 13 is formed so that the opening area thereof decreases by constricting one side of the pressure generating chamber 12 from the X direction. The communication path 14 has substantially the same width as the pressure generating chambers 12 in the X direction. A communication portion 15 is formed on the outside (+Y direction side) of the communication path 14. The communication portion 15 forms one portion of a manifold 100. The manifold 100 is a common ink chamber for each pressure generating chamber 12. In this way, a liquid flow channel formed from the pressure generating chamber 12, the ink supply path 13, the communication path 14, and the communication portion 15 is formed on the flow channel-forming substrate 10.

A nozzle plate 20 manufactured from SUS is bonded to one surface (surface on the -Z direction side) of the flow channel-forming substrate 10. The nozzle openings 21 are arranged in parallel along the X direction in the nozzle plate 20. The nozzle openings 21 communicate with respective pressure generating chambers 12. It is possible for the nozzle plate 20 to be bonded to the flow channel-forming substrate 10 by an adhesive, a heat welding film, or the like.

The diaphragm 50 is formed on the other surface (surface on the +Z direction side) of the flow channel-forming substrate 10. The diaphragm 50 is configured by an elastic film 51 formed on the flow channel-forming substrate 10 and a zirconium oxide layer 52 formed on the elastic film 51. The elastic film 51 is formed from silicon dioxide (SiO₂) or the like, and the zirconium oxide layer 52 is formed by thermal oxidation of zirconium film. The elastic film 51 need not be a separate member to the flow channel-forming substrate 10. A portion of the flow channel-forming substrate 10 may be worked to be thin and the thin portion may be used as the elastic film. The thickness of the zirconium oxide layer 52 is approximately 20 nm. The zirconium oxide layer 52 has a function as a stopper that prevents the potassium and sodium that are constituent elements of the piezoelectric layer 70 from passing through the first electrode 60 and reaching the substrate 10 when forming the piezoelectric layer 70, described later.

The piezoelectric element 300 that includes the first electrode 60, the seed layer 65, the piezoelectric layer 70, and the second electrode 80 is formed on the zirconium oxide layer 52 via the adhesive layer 56 with a thickness of approximately 10 nm. The adhesive layer 56 is formed from a titanium oxide (TiO_{X}) layer, a titanium (Ti) layer, a silicon nitride (SiN) layer, or the like, and has a function by which the adhesiveness of the piezoelectric layer 70 and the diaphragm 50 is improved. In a case of using the titanium oxide (TiOx) layer, the titanium (Ti) layer, or the silicon nitride (SiN) layer as the adhesive layer, the adhesive layer 56 has a function as a stopper that prevents the potassium and sodium that are constituent elements of the piezoelectric layer 70 from passing through the first electrode 60 and reaching the substrate 10 when forming the piezoelectric layer 70, described later, similarly to the previously described zirconium oxide layer 52. The adhesive layer 56 can be omitted.

In the embodiment, the piezoelectric element 300 is configured including the diaphragm 50, the adhesive layer 56, the first electrode 60, the seed layer 65, the piezoelectric layer 70, and the second electrode 80. The piezoelectric element 300 provided to be displaceable on the flow channel-forming substrate 10 becomes the piezoelectric actuator device according to the embodiment.

In the embodiment, the diaphragm 50 and the first electrode 60 are displaced according to the displacement of the piezoelectric layer 70 having electromechanical conversion characteristics. That is, in the embodiment, the diaphragm 50 and the first electrode 60 substantially have a function as a diaphragm. The elastic film 51 and the zirconium oxide layer 52 may be omitted, and only the first electrode 60 may function as the diaphragm. In a case in which the first electrode 60 is provided directly on the flow channel-forming substrate 10, it is preferable for the first electrode 60 to be protected with an insulating protective film or the like so that the ink does not contact first electrode 60.

The first electrode 60 is separated for each pressure generating chamber 12, that is, the first electrode 60 is configured as a separate electrode that is independent for each pressure generating chamber 12. The first electrode 60 is formed with a narrower width in the X direction than the width of the pressure generating chamber 12. The first electrode 60 is formed with a wider width in the Y direction than the width of the pressure generating chamber 12. That is, both end portions of the first electrode 60 are formed up to outside the region with respect to the pressure generating chamber 12 in the Y direction. A lead electrode 90 is connected to one end portion (end portion on the -Y direction side) of the first electrode 60.

The piezoelectric layer 70 is provided between the first electrode 60 and the second electrode 80. The piezoelectric layer 70 is formed with a wider width in the X direction than the width of the first electrode. The piezoelectric layer 70 is formed with a wider width in the Y direction than the length in the Y direction of the pressure generating chamber 12. The end portion (end portion on the +Y direction side) on the ink supply path 13 side of the piezoelectric layer 70 in the Y direction is formed further to the outside than the end portion of the first electrode 60. In other words, the other end portion (end portion on the +Y direction side) of the first electrode 60 is covered by with the piezoelectric layer 70. Meanwhile, one end portion (end portion on the -Y direction side) of the piezoelectric layer 70 is further to the inside than one end portion (end portion on the -Y direction side) of the first electrode 60. In other words, the one end portion (end portion on the -Y direction side) of the first electrode 60 is not covered with the piezoelectric layer 70.

The second electrode 80 is continuously provided along the X direction on the piezoelectric layer 70, the first electrode 60, and the diaphragm 50. In other words, the second electrode 80 is configured as a common electrode shared by the plurality of piezoelectric layers 70. Rather than the upper second electrode 80, the lower first electrode 60 may be formed and used as the common electrode.

A protective substrate 30 is bonded on the flow channel-forming substrate 10 on which the above-described piezoelectric element 300 is formed by the adhesive 35. The protective substrate 30 includes a manifold portion 32. At least a portion of the manifold 100 is configured by the manifold portion 32. The manifold portion 32 according to the embodiment penetrates the protective substrate 30 in the thickness direction (Z direction), and is formed along the width direction (X direction) of the pressure generating chamber 12. The manifold portion 32 communicates, as described above, with the communication portion 15 of the flow channel-forming substrate 10. Through these configurations, the manifold 100 that is a common ink chamber for each pressure generating chamber 12 is configured.

On the protective substrate 30, a piezoelectric element holding portion 31 is formed on a region that includes the piezoelectric element 300. The piezoelectric element holding portion 31 includes a space large enough not to impede the operation of the piezoelectric element 300. The space may or may not be sealed. A through hole 33 that penetrates the protective substrate 30 in the thickness direction (Z direction) is provided in the protective substrate 30. The end portion of the lead electrode 90 is exposed in the through hole 33.

A driving circuit 120 that functions as a signal processor is fixed on the protective substrate 30. It is possible to use a circuit substrate, a semiconductor integrated circuit (IC), or the like as the driving circuit 120. The driving circuit 120 and the lead electrode 90 are electrically connected via a connection wiring 121. The driving circuit 120 is able to be electrically connected to a printer controller 200.

The driving circuit 120 functions as a control unit according to the embodiment.

A compliance substrate 40 formed from a sealing film 41 and a fixing plate 42 is bonded on the protective substrate 30. The region facing the manifold 100 of the fixing plate 42 is an opening portion 43 that is completely removed in the thickness direction (Z direction). One surface (surface on the -Z direction side) of the manifold 100 is sealed only with a sealing film 41 having flexibility.

Next, the piezoelectric element 300 will be described in detail. The piezoelectric element 300 includes the first electrode 60, the second electrode 80, and the piezoelectric layer 70 provided between the first electrode 60 and the second electrode 80. The piezoelectric element 300 includes a seed layer 65 provided between the first electrode 60 and the piezoelectric layer 70. The thickness of the first electrode 60 is approximately 200 nm. The thickness of the seed layer 65 is 10 nm or more to 100 nm or less. The piezoelectric layer 70 is a so-called thin film piezoelectric body with a thickness of 50 nm or more to 2000 nm or less. The thickness of the second electrode 80 is approximately 50 nm. The given thicknesses of each element are all examples and can be modified within a scope not departing from the scope of the invention as defined by the claims.

A noble metal such as platinum (Pt) or iridium (Ir) is suitable as the material of the first electrode 60 and the second electrode 80. The material of the first electrode 60 and the second electrode 80 is not limited, as long as it is a material having conductivity. The material of the first electrode 60 and the material of the second electrode 80 may be the same or may be different.

The seed layer 65 is configured from a complex oxide with an ABO₃-type perovskite structure that includes K and Nb. The constitution thereof is represented by KNbO₃. The seed layer 65 controls the orientation of the KNN-based piezoelectric layer 70 formed on the seed layer 65 to be preferentially oriented on the (110) plane. In a case of forming the piezoelectric layer 70 with a wet method, described in detail later, diffusion of the component elements is generated between the seed layer 65 and the piezoelectric layer 70 when the piezoelectric layer 70 is baked, and there is a possibility that it becomes difficult to detect the interface between the seed layer and the piezoelectric layer 70 in which the seed layer and the piezoelectric layer are not mixed. Even in such a case, it is thought that a region where the density of the metal elements (K and Nb) stemming from the seed layer 65 is high is present on the first electrode 60 side of the piezoelectric layer 70, and it is possible to determine that the high density region is the seed layer 65.

In the perovskite structure, the A site is coordinated with 12 oxygen atoms, and the B site is coordinated with 6 oxygen atoms, thereby forming an octahedron. In the perovskite that configures the seed layer 65, K is positioned at the A site and Nb at the B site. The ratio of A/B, inevitable constitution deviations due to partial loss of the elements, partial substitution of the elements, and the like are permitted within a range of approximately 0.85 to 1.20 when the stoichiometric proportion is 1.

The piezoelectric layer 70 is a complex oxide with a perovskite structure represented by the general formula ABO₃, and includes a piezoelectric material formed from the KNN-based complex oxide represented by the following formula (2).

(K_{X}, Na_{1-X})NbO₃ (2)

The piezoelectric layer 70 is formed from a polycrystal that is preferentially orientated on the (110) plane. Although the piezoelectric material formed from the KNN-based complex oxide tends to be naturally oriented on the (100) plane, in the embodiment, the material is preferentially oriented on the (110) plane by the orientation being controlled by the seed layer 65.

The piezoelectric layer 70 is a polycrystal having a thickness of 50 nm or more to 2000 nm or less. The X-ray diffraction peak position (2θ) derived from the (110) plane of the piezoelectric layer is 31.6° or more to 32.5° or less.

The complex oxide represented by the above formula (2) is a so-called KNN-based complex oxide. Because the KNN-based complex oxide is a non-lead based piezoelectric material in which the content of lead (Pb) or the like is suppressed, the biocompatibility is superior, and the environmental burden is also low. Moreover, because the KNN-based complex oxide has superior piezoelectric characteristics among non-lead based piezoelectric materials, the KNN-based complex oxide is advantageous in the improvement of various characteristics. Additionally, because the KNN-based complex oxide has a comparatively high Curie temperature, and is also not easily depolarized due to temperature increases compared to other non-lead based piezoelectric materials (for example, BNT-BKT-BT; [(Bi, Na)TiO₃]-[(Bi, K)TiO₃]-[BaTiO₃]), the KNN-based complex oxide can be used at high temperatures.

In the above formula (2), the content of K is 54 mol% or more to the total molar mass of the metal element that configures the A site, and it is preferable that the content of Na is 30 mol% or more to the total molar mass of the metal element that configures the A site. Accordingly, the complex oxide having an advantageous constitution for piezoelectric characteristics is obtained.

The piezoelectric material that configures the piezoelectric layer 70 may be a KNN-based complex oxide, and is not limited to the constitution represented to the above formula (2). For example, another metallic element (additive) may be included at the A site or the B site of the potassium sodium niobate. Examples of such additives include manganese (Mn), lithium (Li), barium (Ba), calcium (Ca), strontium (Sr), zirconium (Zr), titanium (Ti), bismuth (Bi), tantalum (Ta), antimony (Sb), iron (Fe), cobalt (Co), silver (Ag), magnesium (Mg), zinc (Zn), and copper (Cu).

One or more types of these additives may be included. Generally, the content of the additive is 20% or less to the total molar mass of the element that is the main component, 15% or less is preferable, and 10% or less is more preferable. By using the additives, various characteristics are improved to make it easy to achieve diversification of the configuration or functions. Even in cases of including the other elements, it is preferable that the complex oxide is configured so as to include an ABO₃-type perovskite structure.

The alkali metal at the A site may be added in excess. It is possible to also represent the complex oxide in formula (2) with the following formula (3). In the following formula (3), a represents the excess A site ratio of K and Na. In a case where a is greater than 1, the constitution becomes one where the alkali metal at the A site is added in excess. For example, if a=1.1, formula (3) represents 110% of K and Na being included when Nb is 100%. In formula (3), a is 1 or more, and preferably 1.2 or less.

(Ka_{X}, Naₐ(_{1-X}))NbO₃ (3)

The wording "complex oxide with an ABO₃-type perovskite structure represented by formula (1)" in the specification is not limited to only a complex oxide with an ABO₃-type perovskite structure represented by formula (1). That is, the wording "including a complex oxide with an ABO₃-type perovskite structure represented by formula (1)" in the specification includes materials represented as a mixed crystal that includes a complex oxide with an ABO₃-type perovskite structure represented by formula (1) and another complex oxide that includes an ABO₃-type perovskite structure. As long as the basic characteristics of the piezoelectric layer 70 are not changed, a material deviating from the stoichiometric constitution due to loss or excess of elements and materials in which a portion of the elements are substituted with another element are also included.

Although the other complex oxide is not limited in the scope of the invention, a non-lead based piezoelectric material in which the content of lead (Pb) is not contained and a non-lead based piezoelectric material in which the content of bismuth (Bi) is not contained are preferable. Accordingly, a piezoelectric element 300 is formed with excellent biocompatibility, and a low environmental burden.

The piezoelectric layer 70 formed from a complex oxide such as above is formed from a polycrystal that is preferentially orientated on the (110) plane in the embodiment. Although the piezoelectric layer 70 formed from the KNN-based complex oxide is easily naturally oriented on the (100) plane, in the embodiment, the piezoelectric layer 70 is caused to be preferentially oriented on the (110) plane using the seed layer 65 that controls the orientation. The piezoelectric layer 70 that is preferentially oriented on the crystal plane on the (110) plane easily achieves improvements in various characteristics compared to a randomly oriented piezoelectric layer. The piezoelectric layer 70 that is preferentially oriented on the (110) plane has improved displacement characteristics compared to a piezoelectric layer that is preferentially oriented on the (100) plane, particularly in a case where a low voltage, for example, 40 V or less, and preferably 35 V or less, is applied. The wording "is preferentially oriented on the (110) plane" includes a case of all of the crystals of the piezoelectric layer 70 being orientated on the (110) plane and a case of most of the crystals (50% or more, preferably 80% or more, and more preferably 90% or more of the crystals) being orientated on the (110) plane.

Since stress in the plane is dispersed and becomes uniform in light of the piezoelectric layer 70 being a polycrystal, stress damage of the piezoelectric element 300 does not easily occur, and the reliability is improved.

Although described in detail later, in the embodiment, the X-ray diffraction peak position (2θ) derived from the (110) plane of the piezoelectric layer 70 is in a range of 31.6° or more to 32.5° or less. Thereby, the displacement for the voltage applied to the piezoelectric layer 70 has superior linearity, and it is possible for the deterioration of the durability of the displacement of the piezoelectric element 300 to be not contained. The X-ray source used when observing the X-ray diffraction peak is CuKα, (wavelength λ=1.54 A).

Here, controlling the X-ray diffraction peak position (2θ) derived from the (110) plane to be in the range of 31.6° or more to 32.5° or less is possible by adjusting the constitution of the material that forms the piezoelectric layer 70, or by controlling the internal stress thereof. Control of the internal stress of the piezoelectric layer 70 is possible through selection of the manufacturing method or adjusting the conditions in the manufacturing steps (film thickness, film formation temperature, or the like).

With respect to the constitution, it is possible to obtain a piezoelectric layer 70 with the X-ray diffraction peak position (2θ) derived from the (110) plane in the range of 31.6° or more to 32.5° or less by making x in the above formula (2) or formula (3) greater than 0 to 0.94 or less.

A chemical solution method, that is, a wet method is preferable as the method of manufacturing the piezoelectric layer 70. According to the wet method, it is possible to comparatively easily manufacture the piezoelectric layer 70 having internal stress, and thereby it is possible to comparatively easily obtain a piezoelectric layer 70 in which the X-ray diffraction peak position (2θ) derived from the (110) plane is in the range of 31.6° or more to 32.5° or less.

The details of the manufacturing method as relate to the control of the internal stress by adjusting the film thickness will be described.

Here, it is preferable that the internal stress of the piezoelectric layer 70 is tensile stress in which the direction in which crystal lattice is compressed is the film thickness direction. When doing so, it is possible to comparatively easily obtain a piezoelectric layer 70 with the X-ray diffraction peak position (2θ) derived from the (110) plane in the range of 31.6° or more to 32.5° or less. That is, in the piezoelectric layer 70 to which tensile stress is applied, the X-ray diffraction peak position (2θ) derived from the (110) plane is shifted to a large value compared to a piezoelectric layer with the same constitution and without tensile stress. In the wet method, it is possible to easily obtain such tensile stress by the piezoelectric material being baked at a high temperature and crystallized. Meanwhile, in a case where the piezoelectric layer is formed by a gas phase method such as sputtering, because it is not necessary for the piezoelectric material to be baked at a high temperature and crystallized, almost no internal stress occurs, and it is difficult to obtain tensile stress such as in a piezoelectric layer 70 formed with a wet method. The X-ray diffraction peak position (2θ) derived from the (110) plane of the piezoelectric layer formed with a gas phase method becomes smaller than the above-described value.

Next, an example of the method of manufacturing the piezoelectric element 300 will be described combined with the method of manufacturing the ink jet recording head 1.

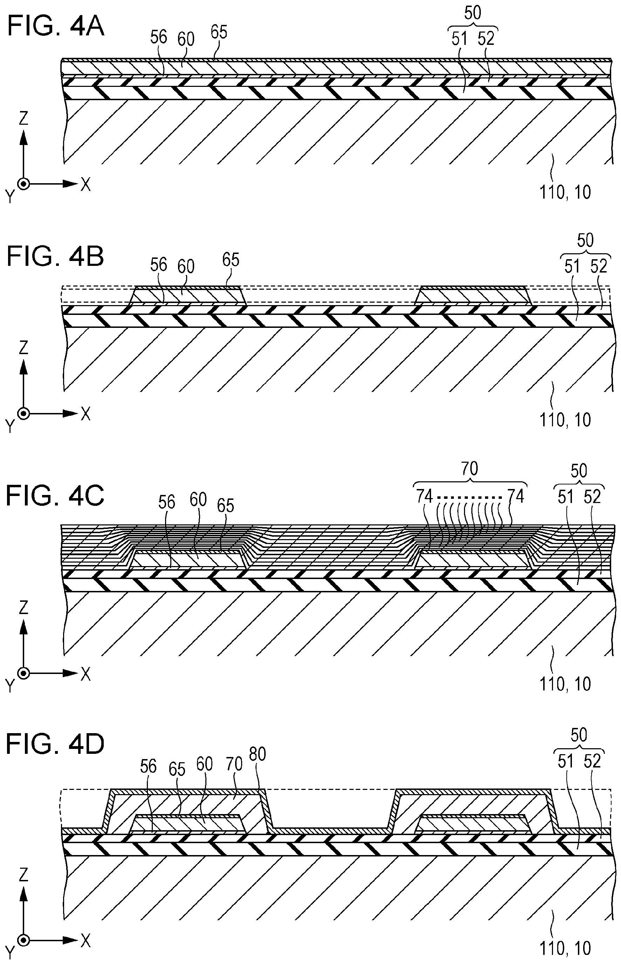

First, the silicon substrate 110 is prepared. Next, the elastic film 51 formed from silicon dioxide is formed on the surface thereof by subjecting the silicon substrate 110 to thermal oxidation. A zirconium film is further formed on the elastic film 51 with a sputtering method, and, by subjecting the film to thermal oxidation, a zirconium oxide layer 52 is obtained. In this way, the diaphragm 50 formed from the elastic film 51 and the zirconium oxide layer 52 is formed. Next, an adhesive layer 56 formed from titanium oxide is formed on the zirconium oxide layer 52. The adhesive layer 56 can be formed by a sputtering method, thermal oxidation, or the like. As shown in Fig. 4A, the first electrode 60 is formed on the adhesive layer 56. It is possible to form the first electrode 60 with gas phase film formation, such as a sputtering method, a vacuum deposition method, or a laser ablation method, or liquid phase film formation, such as a spin coating method.

Next, a seed layer 65 is formed on the first electrode 60. It is possible to form the seed layer 65 with a wet method such as a metal-organic decomposition (MOD) method, a sol-gel method, and the like. It is possible for the seed layer 65 to be formed using solid phase methods such a laser ablation method, a sputtering method, a pulse laser deposition method (PLD method), a CVD method, and an aerosol deposition method.

The specific procedure in a case of forming the seed layer 65 with a wet method is as outlined below. First, a precursor solution for the seed layer 65 formed from an MOD solution or a sol that includes a metal precursor is prepared. The precursor solution is applied on a substrate on which the diaphragm 50, the adhesive layer 56, and the first electrode 60 are formed and a precursor film is formed (coating step). Next, the precursor film is heated to a predetermined temperature, for example, 130°C to 250°C and dried for a fixed time (drying step). Next, pyrolyzing is carried out by heating the dried precursor film to a predetermined temperature, for example, 300°C to 450°C and holding for a fixed time (pyrolyzing step). Finally, when the pyrolyzed film is crystallized by being heated to a higher temperature, for example, approximately 650°C to 800°C, and held for a fixed time at this temperature, the seed layer 65 is completed (baking step).

The precursor solution for the seed layer 65 is a solution in which a metal complex that is able to form the complex oxide that includes K and Nb by baking is dissolved or dispersed in an organic solvent. Examples of the metal complex that includes K include potassium carbonate, and potassium acetate. Examples the metal complex that includes Nb include pentaethoxyniobium. At this time, two or more types of the metal complexes may be used together. Potassium carbonate and potassium acetate may be used together as the metal complex that includes K. Examples of the solvent include 2-n-butoxy ethanol or n-octane or a mixed solvent thereof. The precursor solution may include an additive that stabilizes the dispersion of the metal complex that includes K or Nb. Examples of such an additive include 2-ethyl hexanoic acid.

By patterning the first electrode 60 and the seed layer 65 at the same time after the first electrode 60 and the seed layer 65 are formed, a shape is formed as shown in Fig. 4B. It is possible for the patterning to be performed by dry etching such as reactive ion etching (RIE) and ion milling, or a wet etching using an etching liquid.

Next, the piezoelectric layer 70 is formed as shown in Fig. 4C. It is preferable for the piezoelectric layer 70 to be formed by a wet method such as an MOD method or a sol-gel method. As shown in Figs. 4C and 4D, the piezoelectric layer 70 formed by a wet method includes a plurality of piezoelectric films 74 formed by the series of steps from the coating step to the baking step. That is, the piezoelectric layer 70 is formed by repeating the series of steps from the coating step to the baking step a plurality of times. The specific formation procedure in a case of forming the piezoelectric layer 70 with a wet method is the same as the steps of forming the seed layer 65 with a wet method other than the feature of using the precursor solution for a piezoelectric film 74 instead of the precursor solution for the seed layer 65. In the series of steps from the coating step to the baking step, the baking step may be carried out after repeating from the coating step to the pyrolyzing step a plurality of times. The piezoelectric layer 70 is preferentially oriented on the (110) plane by the alignment being controlled by the seed layer 65.

The precursor solution for the piezoelectric film 74 is a solution in which a metal complex that is able to form the complex oxide that includes K, Na, and Nb by baking is dissolved or dispersed in an organic solvent. At this time, a metal complex that includes an additive such as Mn may be further mixed.

Examples of the metal complex that includes K include potassium carbonate, and potassium acetate. Examples of the metal complex including Na include sodium carbonate and sodium acetate. Examples the metal complex that includes Nb include pentaethoxyniobium. At this time, two or more types of the metal complexes may be used together. Potassium carbonate and potassium acetate may be used together as the metal complex that includes K. Examples of the solvent include 2-n-butoxy ethanol or n-octane or a mixed solvent thereof. The precursor solution may include an additive that stabilizes the dispersion of the metal complex including K, Na, or Nb. Examples of such an additive include 2-ethyl hexanoic acid.

When forming the seed layer 65 or the piezoelectric layer 70 with a wet method, examples of the heat apparatus used in the drying step, the pyrolyzing step, and the baking step include a rapid thermal annealing (RTA) apparatus that heats through radiation of an infrared lamp and a hot plate.

In the embodiment, an alkali metal (K, Na) is included in the piezoelectric material. The alkali metal easily diffuses in the first electrode 60 or the adhesive layer 56 in the baking step. Provisionally, when the alkali metal passes through the first electrode 60 and the adhesive layer 56 to reach the silicon substrate 110, a reaction with the silicon occurs. However, in the embodiment, the zirconium oxide layer 52 or the adhesive layer 56 fulfills the stopper function of the alkali metal. Accordingly, it is possible to prevent a situation in which the alkali metal reaches the silicon substrate 110.

It is preferable that the thickness of the seed layer 65 is set to between 10 nm or more to 50 nm or less. It is preferable that the film thickness of the piezoelectric film 74 is 100 nm or more to 200 nm or less.

When the film thickness of the seed layer 65 is set to 50 nm or less, and the layer is crystallized, the in-plane lattice constant of the seed layer 65 expands according to the stress that is generated by the difference in the coefficients of linear expansion of the seed layer 65 and the substrate 110. The difference between the lattice constant of the seed layer 65 and the lattice constant of the first layer of the piezoelectric film 74 increases, and an effect whereby the stress is relaxed between the seed layer 65 and the first layer of the piezoelectric film 74 is generated. However, because remaining stress is present concentrated between the substrate 110 (strictly speaking, the first electrode 60) and the seed layer 65, it is possible to maintain an appropriate internal stress in the entire piezoelectric layer 70. Meanwhile, when the film thickness of the seed layer 65 drops below 10 nm, because it is difficult for the seed layer 65 to withstand the stress or to substantially exhibit a function as a film by being too thin, it becomes difficult for an appropriate internal stress to be generated.

It is preferable that the thickness of the piezoelectric layer 70 (total thickness of the plurality of piezoelectric films 74) is 50 nm or more to 2000 nm or less. When the thickness of the piezoelectric layer 70 is thinner than this range, the characteristics are not sufficiently obtained, whereas, when the thickness is greater than this range the potential for cracks to occur increases. If the thickness of the piezoelectric layer 70 is 550 nm or more to 1250 nm or less, the characteristics are better obtained, and the potential for cracks to occur is further reduced.

Thereafter, the piezoelectric layer 70 formed from a plurality of piezoelectric films 74 is patterned to have a shape as shown in Fig. 4D. It is possible for the patterning to be performed by dry etching such as reactive ion etching and ion milling, or wet etching using an etching liquid. Thereafter, the second electrode 80 is formed on the piezoelectric layer 70. It is possible to form the second electrode 80 by the same method as the first electrode 60. The piezoelectric element 300 provided with the first electrode 60, the piezoelectric layer 70, and the second electrode 80 is completed by the above steps. In other words, the parts where the first electrode 60, the piezoelectric layer 70, and the second electrode 80 overlap become the piezoelectric element 300.

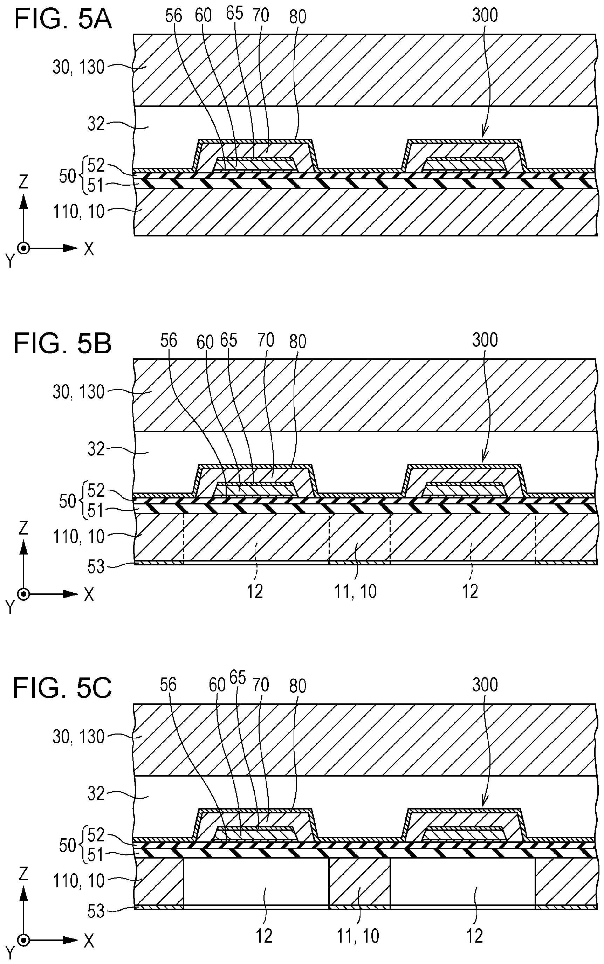

Next, as shown in Fig. 5A, a protective substrate wafer 130 is bonded to the surface on the piezoelectric element 300 side of the silicon substrate 110 via the adhesive 35 (refer to Fig. 3B). Thereafter, the surface of the protective substrate wafer 130 is thinned by shaving. A manifold portion 32 and a through hole 33 (refer to Fig. 3B) is formed in the protective substrate wafer 130. Next, as shown in Fig. 5B, a mask film 53 is formed on the surface of the opposite side to the piezoelectric element 300 of the silicon substrate 110, and patterned to a predetermined shape. As shown in Fig. 5C, anisotropic etching (wet etching) using an alkaline solution such as KOH is carried out on the silicon substrate 110 via the mask film 53. In so doing, an ink supply path 13, a communication path 14, and a communication portion 15 (refer to Fig. 3B) are formed in addition to the pressure generating chamber 12 corresponding to each piezoelectric element 300.

Next, unnecessary parts of the outer circumferential portions of the silicon substrate 110 and the protective substrate wafer 130 are cut and removed by dicing or the like. A nozzle plate 20 is bonded to the surface on the opposite side to the piezoelectric element 300 of the silicon substrate 110 (refer to Fig. 3B). A compliance substrate 40 is bonded to the protective substrate wafer 130 (refer to Fig. 3B). A chip assembly for the ink jet recording head 1 is completed by the steps up to here. The ink jet recording head 1 is obtained by dividing the assembly into individual chips.

### Examples

Below, examples of the invention will be described.

### Examples 1 to 4

An elastic film 51 formed from a silicon dioxide film was formed on the substrate by thermally oxidizing the surface of a 6-inch silicon substrate. Next, a zirconium oxide layer 52 was formed by sputtering a zirconium film on the elastic film 51 and thermally oxidizing the zirconium film. A titanium layer was further sputtered on the zirconium oxide layer and an adhesive layer 56 with a thickness of 20 nm was prepared. Platinum was further sputtered on the adhesive layer 56, and a first electrode 60 with a thickness of 200 nm was formed.

Next, the seed layer 65 was formed with the following procedure. First, each of n-octane, 2-n-butoxyethanol, and 2-n-ethylhexane acidic solution of potassium acetate and pentaethoxyniobium were mixed and a precursor solution was prepared so as to have a KNbO₃ constitution.

Next, the prepared precursor solution was applied to the substrate on which the first electrode 60 is formed by a spin coating method (coating step). Next, the substrate was put on a hot plate, and dried at 180°C for several minutes (drying step). Next, degreasing was carried out at 350°C for several minutes on the substrate on the hotplate (pyrolyzing step). Baking was carried out at 700°C for five minutes with a rapid thermal annealing (RTA) apparatus (baking step). Through the above steps, the seed layer 65 with a thickness of 10 nm was obtained.

Next, the adhesive layer 56, the first electrode 60, and the seed layer 65 were patterned at the same time.

Next, the piezoelectric layer 70 was formed on the seed layer 65 with the following procedure. First an n-octane solution of potassium acetate, an n-octane solution of sodium acetate, and an n-octane solution of pentaethyoxyniobium were mixed and a precursor solution was prepared. Four types of precursor solution were prepared so as to have constitutions where the value of x in the following formula (4) is 0.01 (Example 1), 0.5 (Example 2), 0.7 (Example 3), and 0.9 (Example 4).

(K_{X}Na₁₋ₓ)NbO₃ (x=0.01, 0.5, 0.7, 0.9) (4)

Next, the prepared precursor solution was applied to the substrate on which the first electrode 60 was formed by a spin coating method (coating step). Next, the substrate was put on a hot plate, and dried at 180°C for several minutes (drying step). Next, degreasing was carried out at 350°C for several minutes on the substrate on the hotplate (degreasing step). After the coating step to the pyrolyzing step were carried out five times, baking was performed at 700°C for five minutes by a rapid thermal annealing (RTA) apparatus (baking step). Seven layers in all of piezoelectric film 74, each formed using the five coating steps, were formed by repeating the above steps seven times. The thickness of the one layer of the piezoelectric film 74 was 100 nm, and the thickness of the entire piezoelectric layer 70 (thickness of the seven piezoelectric films 74) was 700 nm.

A second electrode 80 with a thickness of 50 nm was prepared on the prepared piezoelectric layer 70 by sputtering indium. Through the above procedure, the piezoelectric elements of Examples 1 to 4 were prepared.

### X-ray Diffraction Pattern

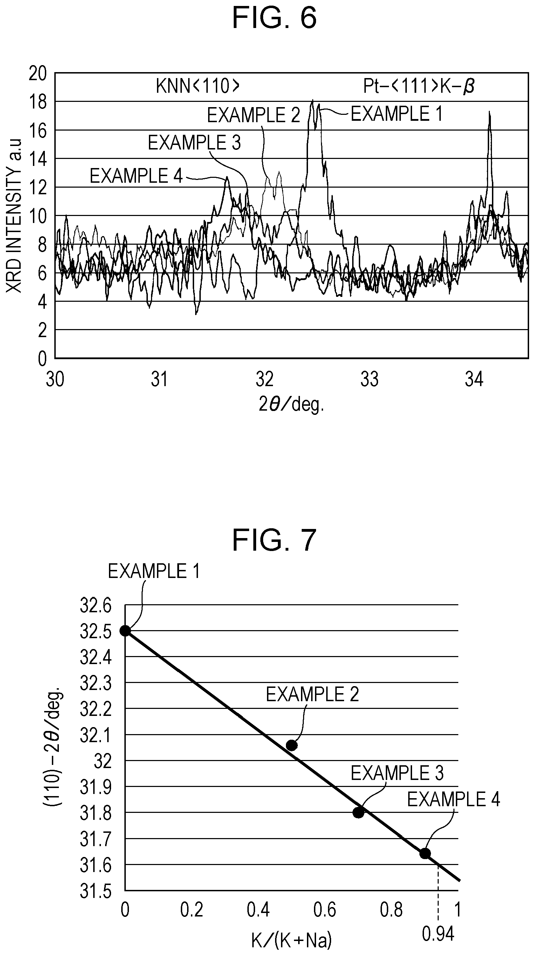

The measurement results near the (110) plane peak of the X-ray diffraction pattern of the piezoelectric layer 70 for Example 1 (x=0.01), Example 2 (x=0.5), Example 3 (x=0.7), and Example 4 (x=0.9) are shown in Fig. 6. Fig. 7 illustrates a graph showing the relationship between the diffraction peak position (2θ) of the (110) plane and x.

According to Fig. 6, in the piezoelectric elements of Examples 1 to 4, it is found that all of the piezoelectric layers 70 are preferentially oriented on (110). It is found that the diffraction peak position (2θ) on the (110) plane y is within the range of x=31.64° to 32.50°. According to Fig. 7, it is found that there is a relationship of y=-0.9698x+32.509 when the value of the diffraction peak position (2θ) of the (110) plane is y. In light of the relational expression, it is found that it is possible to control the diffraction peak position (2θ) of the (110) plane to 31.6° or more to 32.5° or less if using a constitution with a range of 0<x≤0.94.

### Example 5

Other than using a precursor solution prepared so that the value of x in the above formula (4) is x=0.94, the piezoelectric element was prepared with the same procedure as Examples 1 to 4.

The results in which the diffraction peak position (2θ) of the (110) plane of the piezoelectric layer of the piezoelectric element were measured was 31.6°. It is attested that the upper limit value (x=0.94) derived from the relational expression in Fig. 7 is valid.

### Comparative Example

Other than not providing the seed layer 65, the piezoelectric element of the comparative example was prepared with the same procedure as Example 2.

As described above, in the piezoelectric element of Example 2, the piezoelectric layer 70 is preferentially oriented on (110). In contrast, once the X-ray diffraction pattern of the piezoelectric layer is analyzed for the piezoelectric element of the comparative example, it is found that the piezoelectric layer is preferentially oriented on the (100) plane.

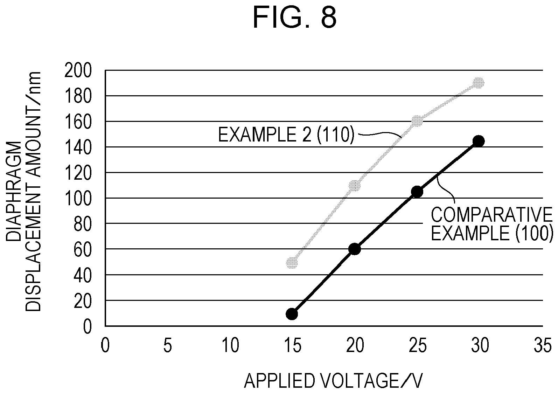

The piezoelectric element of the comparative example and the piezoelectric element of Example 2 were mounted to liquid ejecting heads provided with a pressure generating chamber 12 each with a width (size in the X direction in Fig. 3A) of 55 µm, and the displacement amount during voltage application to the diaphragm 50 was measured. The displacement amount is measured using a Doppler displacement sensor. The results thereof are shown in Fig. 8. According to Fig. 8, it was found that the liquid ejecting head to which the piezoelectric element of Example 2 was mounted has greater displacement compared to the liquid ejecting head to which the piezoelectric element of the comparative example was mounted. Since the crystal system of the KNN-based piezoelectric material is a monoclinic system, the polarization axis is present in the <111> direction. The rotation angle of the polarization during application of the electrical field increases more in the (110) arrangement than in the (100) arrangement. Thus, when driving with a comparatively low voltage, the rotation angle of the polarization is large, and significant displacement is obtained with the (110) arrangement. The results in Fig. 8 support this thinking.

### Other Embodiments

Below, various modifications within the scope of the invention will be described. Thus, the basic configuration of the invention is not limited to the above aspects.

In the above embodiments, the silicon substrate 110 was given as an example of the material of the flow channel-forming substrate 10. However, the material of the flow channel-forming substrate 10 may be SOI, glass, or the like. Because there is potential for any of the materials deteriorating when reacting with the piezoelectric layer-derived alkali metal, providing a zirconium oxide layer that fulfills a K or Na stopper function is significant.

In the above embodiments, an example of the piezoelectric element application device was described with the ink jet recording head as an example. However, it is naturally possible for the piezoelectric element of the invention to be applied to a liquid ejecting head that ejects a liquid other than ink. Examples of liquid ejecting heads that eject a liquid other than ink include various recording heads used in image recording apparatuses, such as printers, color material ejecting heads used to manufacture color filters, such as liquid crystal displays, electrode material ejecting heads used to form electrodes, such as organic EL displays and field emission displays (FED), and biological organic substance ejecting heads used to manufacture bio chips.

The piezoelectric element according to the invention is not limited to a liquid ejecting head, and may be used in other piezoelectric element application devices. Examples of the other piezoelectric element application devices include ultrasound devices, such as ultrasound transmitters, ultrasound motors, temperature-electric converters, pressure-electrical converters, ferroelectric transistors, piezoelectric transformers, and filters such as light blocking filters for harmful light rays, such as ultraviolet rays, optical filters using photonic crystal effects through formation of quantum dots, and optical filters using optical interference of thin films. The invention is also applicable to a piezoelectric element used as a sensor and a piezoelectric element used as a ferroelectric memory. Examples of sensors in which the piezoelectric element is used include infrared sensors, ultrasound sensors, thermosensitive sensors, pressure sensors, pyroelectric sensors, and gyro sensors (angular velocity sensors).

Additionally, it is possible to favorably use the piezoelectric element according to the invention as a ferroelectric element. Examples of the ferroelectric element that is able to be favorably applied include a ferroelectric transistor (FeFET), a ferroelectric arithmetic circuit (FeLogic) and a ferroelectric capacitor. It is possible to favorably use the piezoelectric element according to the invention as a pyroelectric element. Examples of the pyroelectric element capable of being favorably used include temperature detectors, biological detectors, infrared ray detectors, terahertz detectors, and thermoelectric converters. These devices are also included in the piezoelectric element application device according to the invention.

The constituent elements shown in the drawings, that is, the thickness of the layers and the like, the width, the relative positional relationships, and the like may be shown exaggerated for illustrating the invention. The wording "above" in the specification is not limited to a position relationship between constituent elements of being "directly above". The expressions "zirconium oxide layer on the substrate" and "first electrode on the zirconium oxide layer" do not exclude including other constituent elements between the substrate and the zirconium oxide layer or between the zirconium oxide layer and the first electrode.

## Claims

1. A piezoelectric element (300), comprising:
a first electrode (60) formed on a substrate (10);
a piezoelectric layer (70) which is formed on the first electrode and includes a complex oxide with an ABO₃-type perovskite structure represented by the following formula (1); and
a second electrode (80) formed on the piezoelectric layer,
wherein a seed layer (65) including a complex oxide with an ABO₃-type perovskite structure in which K and Nb are included is between the first electrode and the piezoelectric layer, and **characterised in that**
the piezoelectric layer is formed from a polycrystal that is preferentially orientated on the (110) plane.
(K_{X}, Na_{1-X})NbO₃ (1)

2. The piezoelectric element according to claim 1,
wherein an X-ray diffraction peak position (2θ) derived from the (110) plane of the piezoelectric layer is 31.6° or more to 32.5° or less.

3. The piezoelectric element according to claim 1 or claim 2,
wherein, in formula (1), x is greater than 0 to 0.94 or less.

4. The piezoelectric element according to any one of the preceding claims,
wherein the piezoelectric layer has a thickness of 50 nm or more to 2000 nm or less.

5. The piezoelectric element according to any one of the preceding claims,
wherein the piezoelectric layer is prepared by a wet method.

6. A piezoelectric element application device, comprising:
the piezoelectric element according to any one of the preceding claims.

7. A method of manufacturing a piezoelectric element (300) that includes a first electrode (60) formed on a substrate (10), a piezoelectric layer (70) which is formed on the first electrode and includes a complex oxide with an ABO₃-type perovskite structure represented by the following formula (1), and a second electrode (80) formed on the piezoelectric layer, the method comprising:
forming a seed layer (65) including a complex oxide with an ABO₃-type perovskite structure in which K and Nb are included on the first electrode, and **characterised in**
forming the piezoelectric layer on the seed layer to be preferentially oriented on the (110) plane.
(K_{X}, Na_{1-X})NbO₃ (1)

## Patentansprüche

1. Piezoelektrisches Element (300), umfassend:
eine erste Elektrode (60), die auf einem Substrat (10) gebildet ist;
eine piezoelektrische Schicht (70), die auf der ersten Elektrode gebildet ist und ein komplexes Oxid mit einer Perowskitstruktur vom ABO₃-Typ enthält, die durch die folgende Formel (1) dargestellt ist; und
eine zweite Elektrode (80), die auf der piezoelektrischen Schicht gebildet ist,
wobei eine Keimschicht (65), die ein komplexes Oxid mit einer Perowskitstruktur vom ABO₃-Typ enthält, in der K und Nb enthalten sind, zwischen der ersten Elektrode und der piezoelektrischen Schicht liegt, und **dadurch gekennzeichnet, dass**
die piezoelektrische Schicht aus einem Polykristall gebildet ist, der vorzugsweise auf der (110) Ebene orientiert ist.
(Kₓ, Na₁₋ₓ)NbO₃ (1)

2. Piezoelektrisches Element nach Anspruch 1,
wobei eine Röntgenbeugungsspitzenposition (2θ), die von der (110) Ebene der piezoelektrischen Schicht abgeleitet ist, 31,6° oder mehr bis 32,5° oder weniger ist.

3. Piezoelektrisches Element nach Anspruch 1 oder 2,
wobei in Formel (1) x größer als 0 bis 0,94 oder kleiner ist.

4. Piezoelektrisches Element nach einem der vorangehenden Ansprüche,
wobei die piezoelektrische Schicht eine Dicke von 50 nm oder mehr bis 2000 nm oder weniger hat.

5. Piezoelektrisches Element nach einem der vorangehenden Ansprüche,
wobei die piezoelektrische Schicht durch ein Nassverfahren hergestellt wird.

6. Piezoelektrische Element-Anwendungsvorrichtung, umfassend:
das piezoelektrische Element nach einem der vorangehenden Ansprüche.

7. Verfahren zur Herstellung eines piezoelektrischen Elements (300), das eine erste Elektrode (60), die auf einem Substrat (10) gebildet ist, eine piezoelektrische Schicht (70), die auf der ersten Elektrode gebildet ist und ein komplexes Oxid mit einer Perowskitstruktur vom ABO₃-Typ enthält, die durch die folgende Formel (1) dargestellt ist, und eine zweite Elektrode (80), die auf der piezoelektrischen Schicht gebildet ist, enthält, das Verfahren umfassend:
Bilden einer Keimschicht (65), die ein komplexes Oxid mit einer Perowskitstruktur vom ABO₃-Typ enthält, in der K und Nb enthalten sind, auf der ersten Elektrode und **gekennzeichnet durch**
Bilden der piezoelektrischen Schicht auf der Keimschicht, sodass sie vorzugsweise auf der (110) Ebene orientiert ist.
(Kₓ, Na₁₋ₓ)NbO₃ (1)

## Revendications

1. Élément piézoélectrique (300) comprenant :
une première électrode (60) formée sur un substrat (10) ;
une couche piézoélectrique (70) qui est formée sur la première électrode et qui comprend un oxyde complexe avec une structure pérovskite de type ABO₃ représentée par la formule (1) suivante ; et
une deuxième électrode (80) formée sur la couche piézoélectrique,
dans lequel une couche d'ensemencement (65), comprenant un oxyde complexe avec une structure pérovskite de type ABO₃ où K et Nb sont inclus, est entre la première électrode et la couche piézoélectrique, et
**caractérisé en ce que** la couche piézoélectrique est formée par un polycristal de préférence orienté sur le plan (110).
(Kₓ, Na₁₋ₓ)NbO₃ (1)

2. Élément piézoélectrique selon la revendication 1,
dans lequel une position de pic de diffraction de rayons X (2θ) dérivée du plan (110) de la couche piézoélectrique est de 31,6° ou plus à 32,5° ou moins.

3. Élément piézoélectrique selon la revendication 1 ou la revendication 2, dans lequel, dans la formule (1), x est supérieur à 0 jusqu'à 0,94 ou moins.

4. Élément piézoélectrique selon l'une quelconque des revendications précédentes, dans lequel la couche piézoélectrique a une épaisseur de 50 nm ou plus à 2000 nm ou moins.

5. Élément piézoélectrique selon l'une quelconque des revendications précédentes, dans lequel la couche piézoélectrique est préparée par une méthode humide.

6. Dispositif d'application d'élément piézoélectrique, comprenant :
l'élément piézoélectrique selon l'une quelconque des revendications précédentes.

7. Procédé de fabrication d'un élément piézoélectrique (300) qui comprend une première électrode (60) formée sur un substrat (10), une couche piézoélectrique (70) qui est formée sur la première électrode et comprend un oxyde complexe avec une structure pérovskite de type ABO₃ représentée par la formule (1) suivante, et une deuxième électrode (80) formée sur la couche piézoélectrique, le procédé comprenant :
la formation d'une couche d'ensemencement (65) comprenant un oxyde complexe avec une structure pérovskite de type ABO₃ où K et Nb sont inclus sur la première électrode, et
**caractérisé par** la formation de la couche piézoélectrique sur la couche d'ensemencement pour être orientée de manière préférée sur le plan (110).
(Kₓ, Na₁₋ₓ)NbO₃ (1)
